# EUROPÄISCHE PATENTANMELDUNG

(11) **EP 3 770 959 A1**
(43) Veröffentlichungstag der Anmeldung: **27.01.2021**
(21) Anmeldenummer: 20183066.8
(22) Anmeldetag: 30.06.2020
(51) Int. Cl.: H01L 23/485, H01L 23/498, H01L 25/07, H01L 23/31, H01L 23/433

(54) **VERBINDUNGSMETHODE FÜR LEISTUNGSMODULE MIT EINER ZWISCHENKREISVERSCHIENUNG**

(30) Priorität: 23.07.2019 DE 102019210902
(71) Anmelder: FRAUNHOFER-GESELLSCHAFT zur Förderung der angewandten Forschung e.V., 80686 München (DE)
(72) Erfinder: HOENE, Eckart, 13355 Berlin (DE)
(74) Vertreter: Pfitzner, Hannes

(57) **Zusammenfassung**

System umfassend ein Leistungsmodul umfassend einen Halbleiter und eine erste Verbindungsstelle und eine zweite Verbindungsstelle, die mit dem Halbleiter elektrisch leitend verbunden ist sowie eine Zwischenkreisverschienung umfassend zumindest zwei Schienen, wobei eine erste der zwei Schienen zumindest ein Kontaktelement aufweist, und wobei das zumindest eine Kontaktelement mit der ersten Verbindungsstelle eine elektrisch leitende Kaltverschweißverbindung formt.

## Beschreibung

Ausführungsbeispiele der vorliegenden Erfindung schaffen ein System umfassend ein Leistungsmodul und eine Zwischenkreisverschienung. Bevorzugte Ausführungsbeispiele der vorliegenden Erfindung beziehen sich auf ein Verbindungsverfahren für niederinduktive Leistungsmodule mit einer Zwischenkreisverschienung.

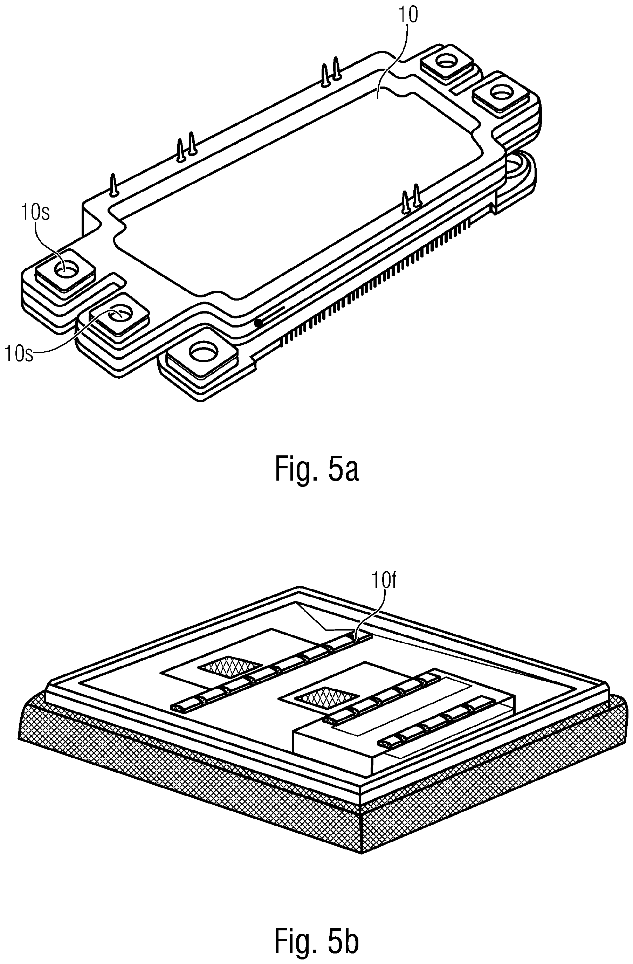

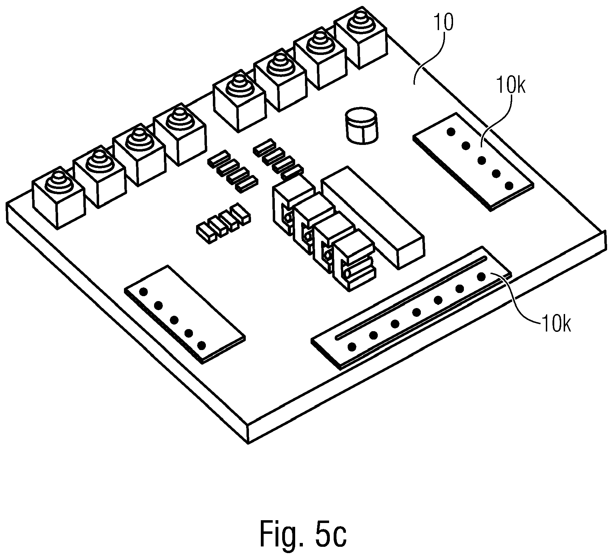

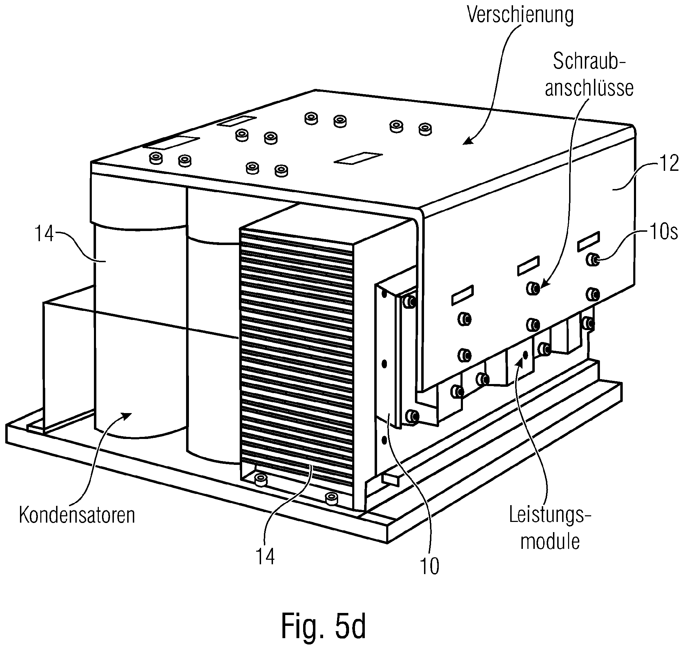

Leistungsmodule mit Leistungshalbleitern, das heißt also beispielsweise mit Halbbrücken oder Dioden zur Stromrichtung, werden über sogenannte Zwischenkreisverschienungen an Zwischenkreiskapazitäten angeschlossen. Um die Effizienz der Leistungsmodule hoch zu halten, sind diese Verbindungen niederinduktiv ausgelegt. Bei hohen Leistungen werden Module für Leistungshalbleiter z.B. mit Schraubanschlüssen (vgl. Fig. 5a) elektrisch angeschlossen. Bei dem Leistungsmodul 10 aus Fig. 5a sind die Schraubanschlüsse mit 10s gekennzeichnet. Eine Anwendung bzw. ein eingebautes Leistungsmodul 10 ist in Fig. 5d gezeigt.

Fig. 5d zeigt das Leistungsmodul 10, das über Schraubanschlüsse 10s an die Zwischenverschienung 12 gekoppelt ist. Die Zwischenverschienung ist wiederum mit Kondensatoren 14 verbunden. Darüber hinaus umfasst die Anordnung auch noch einen Kühlkörper 18, der mit dem Leistungsmodul 10 verbunden wird. Das Leistungsmodul 10 ist auf den Kühlkörper 18 aufgesetzt und mit diesem per Schrauben verbunden. Auf einer gegenüberliegenden Seite (zweite Hauptoberfläche gegenüber der ersten Hauptoberfläche, die mit dem Kühlkörper 18 in Kontakt steht) wird mittels den Schraubanschlüssen 10s die Verschienung befestigt.

Diese sehr praktikable Lösung hat den Nachteil, dass mit den Anschlüssen parasitäre Induktivitäten in der Größenordnung von 10 nH entstehen. Für schnell schaltendende Halbleiter führen diese Induktivitäten zu Überspannungen und Schwingungen, die die Schaltgeschwindigkeiten begrenzen. Insofern ist es ein allgemeines Ziel, die Zwischenkreisinduktivitäten (von Leistungsmodulen) niedrig zu halten. Um die Niederinduktivität der Anschlüsse zu erreichen, wurde ein Verfahren zur Befestigung mittels Spiralfedern entwickelt. Beispielsweise zeigt Fig. 10b solche Verbindungsmittel 10f zum Ankoppeln eines Leistungsmoduls 10 (siehe Fig. 10c) an Zwischenkreisinduktivitäten. Die Spiralfedern 10f sind beispielsweise Teil der Zwischenkreisverschienung (vgl. Bezugszeichen 12 in Fig. 10d). Das Leistungsmodul 10 weist hierfür breite Kontaktflächen 10k auf, die mit den Federn 10f verbunden werden können. Diese Lösung wird derzeit nicht gut angenommen, da mechanischer Druck für den Kontakt benötigt wird und die Federn altern. Deshalb besteht der Bedarf nach einem verbesserten Ansatz.

Aufgabe der vorliegenden Erfindung ist es, eine Verbindungstechnik zur Kopplung der Zwischenkreisverschienung bzw. einer Verschienung allgemein und einem Leistungsmodul zu schaffen.

Die Aufgabe wird durch den Gegenstand der unabhängigen Patentansprüche gelöst.

Ausführungsbeispiele der vorliegenden Erfindung schaffen ein System umfassend ein Leistungsmodul mit zumindest einem Halbleiter, eine erste Verbindungsstelle und eine zweite Verbindungsstelle, die mit dem Halbleiter elektrisch leitend verbunden ist; eine Zwischenkreisverschienung umfassend zumindest zwei Schienen, wobei eine erste der zwei Schienen zumindest ein Kontaktelement aufweist und wobei das zumindest eine Kontaktelement mit der ersten Verbindungsstelle eine elektrisch leitende Kaltverschweißverbindung formt. Entsprechend Ausführungsbeispielen wird die elektrisch leitende Verbindung mittels Kaltverschweißen und/oder mittels Kaltpressverschweißen geformt.

Ausführungsbeispiele der vorliegenden Erfindung liegt die Erkenntnis zugrunde, dass ein Leistungsmodul mit einer Zwischenkreisverschienung über eine sogenannte Kaltschweißverbindung elektrisch leitend verbunden werden kann. Hierzu weist das Leistungsmodul eine erste Verbindungsstelle auf, die mit einem Kontaktelement einer der Schienen der Zwischenkreisverbindung in Eingriff gebracht wird. Durch dieses In-Eingriff-Bringen, z. B. unter Verwendung von Druck, erfolgt ein Kaltverschweißen. Als Kaltverschweißung bezeichnet man eine Verbindung, die auf dem Phänomen basiert, dass bereits bei Raumtemperatur Objekte miteinander in eine Art / fast stoffschlüssige Verbindung gebracht werden können. Hierbei erfolgt eine plastische Verformung durch die starke Annäherung der Kontaktflächen.

Entsprechend Ausführungsbeispielen sind die in Eingriff zu bringenden Elemente (Verbindungsstellen und Kontaktelemente) vorzugsweise metallisch ausgebildet, was, erstens, gute plastische Verformbarkeit ermöglicht und, zweitens, gleichzeitig elektrisch leitend ist. Entsprechend einem Ausführungsbeispiel kann die Verbindungsstelle zumindest eine metallisierte Bohrung aufweisen. Das Gegenstück/das Kontaktelement kann entsprechend einem Ausführungsbeispiel zumindest einen Stift oder einen Stift mit einem quadratischen, runden, ovalen oder anderen Querschnitt aufweisen. Entsprechend Ausführungsbeispielen erstreckt sich das Kontaktelement/der Stift in dieselbe Richtung wie die metallisierte Bohrung. Umgekehrt heißt das, dass, wenn man von einem quadratischen Querschnitt ausgeht, dieser quadratische Querschnitt sich in eine Ebene erstreckt, die senkrecht zu der Achse der metallisierten Bohrung liegt.

Entsprechend einem weiteren Ausführungsbeispiel kann das Leistungsmodul zwei Verbindungsstellen umfassen, die mit dem Halbleiter elektrisch leitend verbunden sind. Hierbei weist dann eine zweite der zwei Schienen zumindest ein Kontaktelement auf, wobei das zumindest eine Kontaktelement der zweiten der zwei Schienen mit der zweiten Verbindungsstelle eine elektrisch leitende Verbindung formt. Als Verbindung kommt wiederum entsprechend Ausführungsbeispielen eine Kaltverschweißung/ Kaltpressverschweißung infrage. Die Realisierung kann wiederum beispielsweise durch einen Stift in Kombination mit einer Bohrung erfolgen. Alternativ wäre es natürlich auch denkbar, dass diese zweite Verbindung anders realisiert ist, z. B. durch eine Oberflächenverbindung, eine Schweißverbindung, eine Ultraschallschweißverbindung oder eine Laserschweißverbindung. Insbesondere die Oberflächenverbindung ist sehr interessant, da bereits durch die erste Verbindung realisiert sein kann, dass eine ausreichend große Anpresskraft vorliegt.

Die zwei Schienen der Zwischenkreisverbindung können beispielsweise durch zwei leitende Lagen mit einer dazwischen liegenden Isolationsschicht gebildet sein. Entsprechend einem Ausführungsbeispiel ragt die eine der zwei leitenden Lagen an dem Ende der Zwischenkreisverschienung über die erste der zwei Lagen hinaus. Hierdurch kann sichergestellt werden, dass, auch wenn die Lagen sich übereinander befinden, beide durch die zwei Lagen geformten Schienen mit einem parallel angeordneten Leistungsmodul verbunden werden können, ohne dass es einer Durchführung der Kontaktstelle durch die andere Lage bedarf. Das Leistungsmodul umfasst eine erste Hauptoberfläche, die der Zwischenkreisverschienung zugewandt ist. Auf dieser ersten Hauptoberfläche ist beispielsweise die zweite Verbindungsstelle angeordnet, wobei bevorzugterweise auch die erste Verbindungsstelle an der ersten Hauptoberfläche vorgesehen ist. Wenn man davon ausgeht, dass die zweite Verbindungsstelle beispielsweise als Kaltschweißverbindung oder Oberflächenverbindung (oder Schweißverbindung, Ultraschallschweißverbindung, Laserschweißverbindung) ausgebildet ist, kann entsprechend Ausführungsbeispielen die zweite der zwei Schienen eine Kröpfung aufweisen, wobei die Kröpfung so geformt ist, dass sie unter Berücksichtigung der Dicke der ersten leitenden Lage und der Dicke der Isolierschicht den Abstand zwischen der ersten und der zweiten leitenden Lage und der ersten Hauptoberfläche des Leistungsmoduls, die der Zwischenkreisverschienung zugewandt ist, definiert.

Der Vollständigkeit halber sei darauf hingewiesen, dass entsprechend Ausführungsbeispielen die Zwischenkreisverschienung mit einer oder mehreren Kapazitäten, die Teil des Systems sind, verbunden sein kann. Insofern hat die Zwischenkreisverschienung die Aufgabe, die Kapazitäten mit dem Leistungsmodul bzw. mit den Leistungshalbleitern auf dem Leistungsmodul elektrisch zu verbinden.

Ein weiteres Ausführungsbeispiel schafft ein Verfahren zur Herstellung des erläuterten Systems. Das Verfahren umfasst den zentralen Schritt des elektrischen Kontaktierens des zumindest einen Kontaktelements mit der ersten Verbindungsstelle mittels Kaltverschweißen oder mittels Kaltpressverschweißen, so dass eine Kaltschweißverbindung ausgebildet wird. Entsprechend Ausführungsbeispielen kann das Verfahren einen Schritt des Einpressens zumindest eines Stiftes, der das Kontaktelement der ersten der zwei Schienen formt, in zumindest eine metallisierte Bohrung des Leistungsmoduls umfassen. Hier wird beim Einpressen eine plastische Verformung geformt. Entsprechend bevorzugten Ausführungsbeispielen sind die Geometrien, insbesondere die Geometrie des Stiftes im Vergleich zur Geometrie der Bohrung so gewählt, dass eine Verformung stattfinden muss, beispielsweise ist der Stift größer oder hat einen rechteckigen Querschnitt, der in den runden Querschnitt der Bohrung gepresst wird, so dass eine Verformung der Querschnitte erfolgt.

Weiterbildungen sind in den Unteransprüchen definiert. Ausführungsbeispiele der vorliegenden Erfindung werden nachfolgend anhand der beiliegenden Zeichnungen erläutert. Es zeigen:
- Fig. 1: eine schematische Darstellung eines Systems mit einem Leistungsmodul und einer Zwischenkreisverschienung gemäß einem Basisausführungsbeispiel;
- Fig. 2: eine schematische Darstellung einer Verbindungsstelle zwischen einer Leiterplatte als Leistungsmodul und einer Zwischenkreisverschienung gemäß einem Basisausführungsbeispiel;
- Fig. 3b: eine schematische Darstellung einer Verbindungsstelle eines Leistungsmoduls und einer Zwischenkreisverschienung gemäß einem weiteren Ausführungsbeispiel;

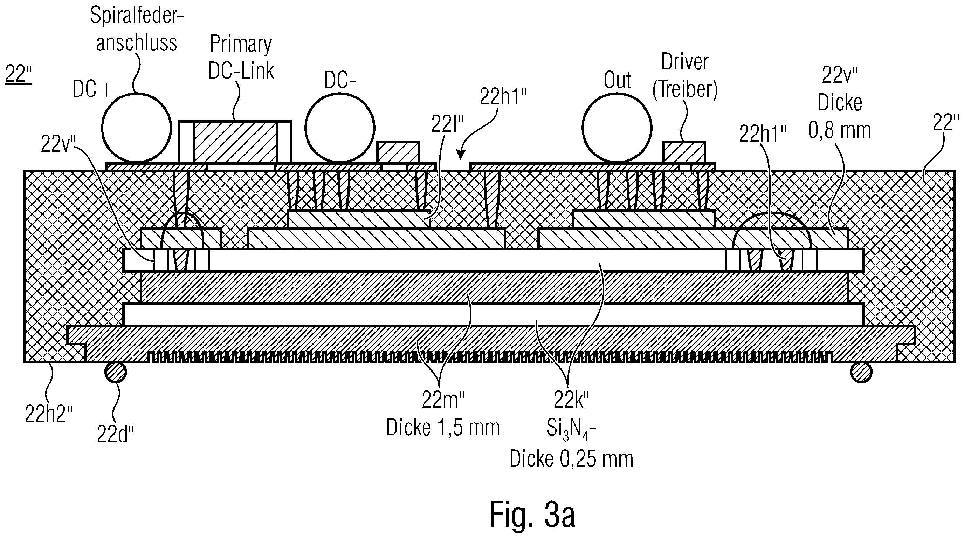

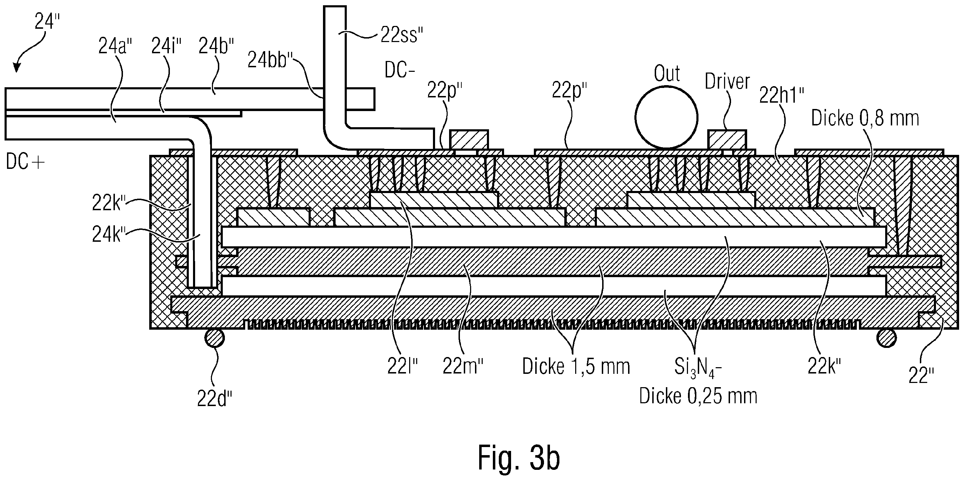

- Fig. 3a: eine detaillierte Darstellung des Leistungsmoduls aus Fig. 3b;

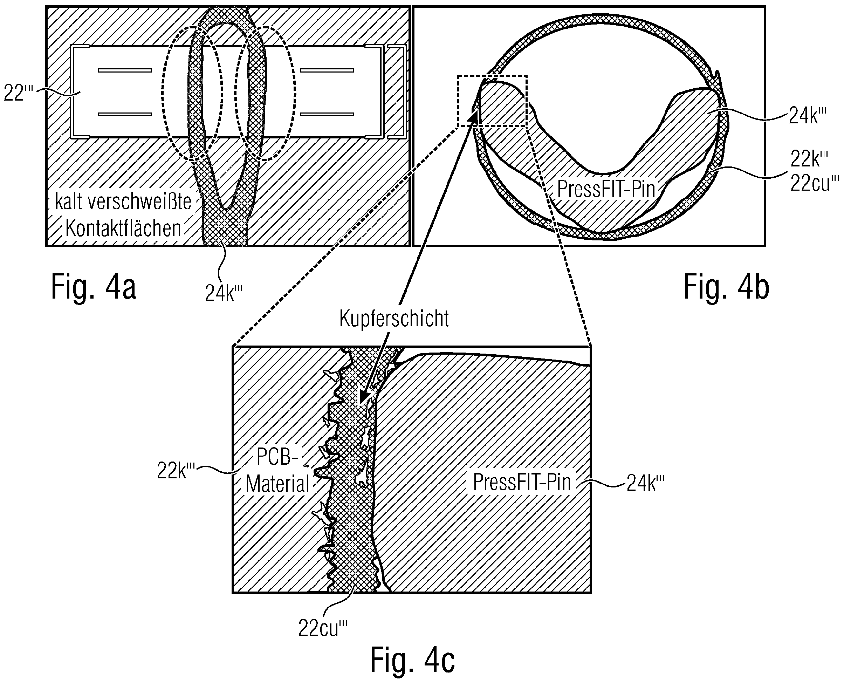

- Fig. 4a-d: schematische Darstellungen zur Illustration einer Kaltschweißverbindung gemäß Ausführungsbeispielen;
- Fig. 5a-d: Illustrationen von Stand der Technik Verbindungen.

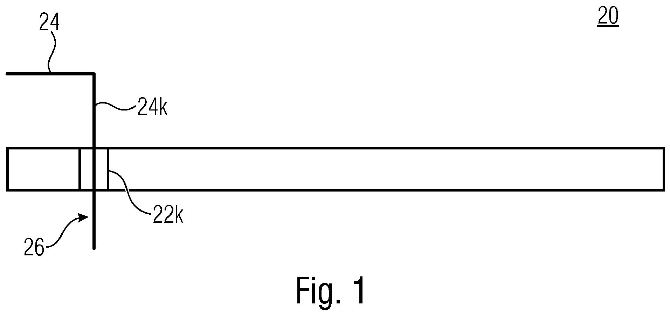

Fig. 1 zeigt ein System 20 mit einem Leistungsmodul 22, das elektrisch mit einer Zwischenkreisverschienung 24 verbunden ist. Die Zwischenkreisverschienung 24 ist mit dem Leistungsmodul 22 über eine sogenannte Kaltschweißverbindung 26 verbunden.

Diese ist in diesem Ausführungsbeispiel wie folgt realisiert. Eine Kontaktstelle 24k, die hier als Stift/Pin realisiert ist, ist in ein Kontaktelement 22k eingeführt. Bei der Kontaktstelle 24k handelt es sich beispielsweise um einen Stift, der aus der Zwischenkreisverschienung 24 herausgebogen ist oder sich allgemein aus der Zwischenkreisverschienung 24 absetzt und zur Kontaktierung der Kontaktstelle 22k dient. Die Kontaktstelle 22k ist als geometrisches Gegenstück zum Kontaktelement 22k, wie z.B. als Bohrung realisiert, wobei die Ausdehnung / der Durchmesser der Bohrung 22k kleiner ist als die geometrischen Ausdehnungen, z. B. der Durchmesser des Stiftes 24k. Um eine gute Verformbarkeit der beiden Elemente 24k und 22k und insbesondere elektrische Leitung zu ermöglichen, sind entsprechend bevorzugten Ausführungsbeispielen die Kontaktelemente 22k und 24k aus Metall ausgeführt bzw. metallisiert. Entsprechend weiteren Ausführungsbeispielen sind die Geometrien der zwei zu verbindenden Elemente 24k und 22k also zueinander gewählt, dass eine Art Übermaßpassung entsteht, wobei das Übermaß so gewählt ist, dass es zu einer plastischen Verformung kommen muss.

Es wird allgemein von einer geometrischen Ausdehnung gesprochen, da der Stift 24k nicht zwingend rund sein muss, sondern es auch denkbar wäre, dass der Stift einen eckigen oder V- / L-förmigen Querschnitt aufweist. Der eckige Querschnitt hat beispielsweise eine größere Diagonale als der Durchmesser der Bohrung 22k und muss sich also zwingend beim Einführen in die Bohrung 22k verformen. Diese Verformung erfolgt plastisch, so dass also durch das Einführen eine dauerhafte Verbindung ausgebildet wird. Unterschiedliche Geometrien für Bohrung oder Stift haben den Vorteil, dass die Überlappbereiche sich sehr leicht formen lassen, da neben den Überlappbereichen durch die unterschiedlichen Geometrien Bereiche entstehen, die "Luft" haben, so dass sich in diese Bereiche das Material verformen kann. Denkbar wäre beispielsweise, dass eine runde Bohrung in Kombination mit einem eckigen Stift Verwendung findet. Es sei angemerkt, dass der Stift 24k oder auch die Bohrung 22k oder auch beide Elemente verformt werden und hierbei eine Verbindung ähnlich einer Schweißverbindung ausbilden. Bezüglich des Verschweißverfahrens sei beispielsweise auf folgende Veröffentlichung hingewiesen: https://www.we-online.com/web/en/intelligente systeme/technologien/ massive einpresstechik/ grundlagen/Grundlagen.php

Bei obigen Ausführungsbeispielen wurde davon ausgegangen, dass die Kontaktstelle 24k der Zwischenkreisverschienung 24 als Stift ausgeführt ist, wobei dies entsprechend weiteren Ausführungsbeispielen genauso umgekehrt sein kann, nämlich dass der Stift auf der Platine des Leistungshalbleiters 22 angeordnet ist. Die Ausrichtung von Stift und Bohrung (Erstreckungsrichtung des Stiftes und Bohrachse der Bohrung) sind so gewählt, dass beim Zusammensetzen diese ineinander fahren können. Beispielsweise können sich die zwei Achsen senkrecht zu der Platine 22 erstrecken. Es wäre selbstverständlich auch ein anderer Winkel, z. B. ein 45°-Winkel oder ähnlich, denkbar. Da nun die Struktur erläutert wurde, wird nachfolgend auf die Funktionsweise des Systems 20 eingegangen. Beim System 20 handelt es sich um eine Variante zur Ankopplung von Zwischenkreiskondensatoren (nicht dargestellt) an ein Leistungsmodul 22. Hierzu kommt eine Verschienung 24 zum Einsatz. Diese umfasst entsprechend Ausführungsbeispielen zwei übereinander laminierte Kupferbleche, von denen eine die positive Versorgungsspannung trägt und die andere die negative. Die Niederinduktivität dieser Verschienung 24 wird erreicht, indem die beiden Bleche möglichst breit ausgeführt werden und möglichst nah übereinander montiert werden, das heißt also mit einer sehr dünnen Isolierschicht dazwischen. Um diese Niederinduktivität nicht zu zerstören, sollte der Übergang in das Modul 22 die gleichen Anforderungen erfüllen, das heißt also möglichst breit und möglichst nah beieinander. Mit der klassischen Montage mit Schrauben kann vor allem letztere Anforderung schlecht erfüllt werden, da das Leistungsmodul allein durch die Verschraubung um einige Faktoren dicker wird. Durch die Verwendung der Kaltverschweißung für zumindest einen Pol wird die Dicke erheblich reduziert.

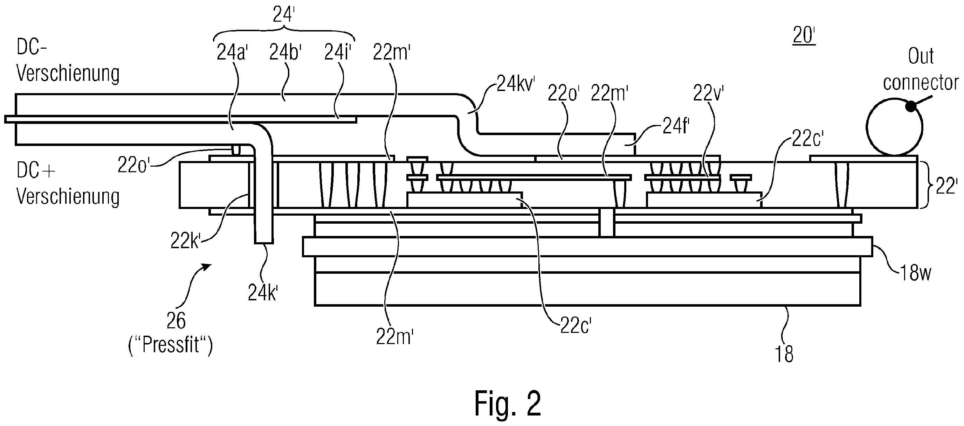

Mögliche Geometrien für flache Leistungsmodule in Leiterplattentechnologien mit Zwischenkreis sind nachfolgend bezugnehmend auf Fig. 2, 3a, 3b und 4a-d erläutert.

Fig. 2 zeigt ein System 20' mit einer Zwischenkreisverschienung 24', die zwei übereinander angeordnete Schienen 24a' und 24b' sowie eine dazwischen angeordnete Isolationsschicht 24i' umfasst. Die Leiterplatte mit den Leistungshalbleitern 22l' ist mit dem Bezugszeichen 22' versehen. Die Leistungshalbleiter 22l' (zumindest einer) sind in die Leiterplatte 22' eingebettet. Bei der dargestellten Variante erfolgt eine Serienschaltung von zwei Elemente 22l' über Metallisierungen 22m' und Vias 22v'.

Die erste Lage der Verschienung 24a' ist mittels einer Kaltverschweißung realisiert, wobei die Verschienung 24b' entweder mit einer Oberflächenkontaktierung oder auch mit einer Kaltverschweißung realisiert sein kann. Entsprechend einer bevorzugten Variante erstrecken sich die Verschienungen 24a und 24b als breite Streifen, z.B. in zwei unterschiedlichen Ebene, parallel zu dem Modul 22'. Hierbei kann die Verschienung 24b lateral über die Verschienung 24a hinausragen, sodass jeweils eine gute Kontaktierung des Moduls an zwei unterschiedlichen lateralen Positionen der Oberfläche des Moduls 22' möglich ist.

In dem dargestellten Beispiel formt die Verschienung 24a'einen oder bevorzugt mehrere Stifte 24k' aus, der durch die Leiterplatte 22' oder, um genau zu sein, durch eine Bohrung/ein Loch 22k' in der Leiterplatte 22' hindurchragt. Die Bohrung 22k' ist auf der Innenseite metallisiert, wobei optional auch auf der Oberseite und der Unterseite Metallisierungen 22o' vorgesehen sein können. Durch den Pressfit wird wiederum die Kaltverschweißung zwischen den Kontaktstellen 22k' und 24k' ausgebildet. Entsprechend weiteren Ausführungsbeispielen kann eine Art Abstandshalter/Isolierung 24o' vorgesehen sein, der zwischen dem lateralen Abschnitt der Verschienung 24a' und der Oberflächenmetallisierung 22m' angeordnet ist und den Abstand und damit auch die Tiefe, in die der Stift 24k' durch die Leiterplatte 22' hindurchragt, einstellt.

Die Verschienung 24b weist bei der Kontaktierung eine abgeflachte Kontaktstelle 24f' auf, die mit der Oberflächenmetallisierung 22o' der Leiterplatte 22 in Eingriff ist. Hierbei kann eine Oberflächenverbindung oder ebenfalls eine Kaltverschweißung ausgebildet werden. Eine mögliche Realisierung besteht darin, dass die Oberflächenmetallisierung 22o' eine Art Kontaktpad, das sich bei entsprechendem Druck plastisch verformt, bildet.

Damit die Verschienung 24b' mit dem Kontaktpad 24o', das sich auf der Oberfläche der Leiterplatte 22, die der Verschienung 24 zugewandt ist, in Berührung gebracht werden kann, weist die Verschienung 24b' eine Kröpfung 24kr' auf. Diese ist so gewählt, dass zumindest die Dicke der Verschienung 24a', wie auch die Dicke der Isolationsschicht 24i', überbrückt wird.

Bezüglich der Verschaltung sei angemerkt, dass die Verschienung 24a' (z. B. DC+ Verschienung) über die Kontaktstelle 22k'/24k' mit den Halbleitern 24l' verbunden ist, wobei diese seriell geschaltet sind und am Ende der Serienschaltung wiederum mit der Verschienung 24b' (DC-) über die Kontaktstelle 22o' und 24f' verbunden ist.

Entsprechend Ausführungsbeispielen sind die Leistungshalbleiter 22l' auf der Unterseite (gegenüber der Hauptoberfläche, die zur Kontaktierung der Verschienung 24 dient bzw. der Verschienung 24, zugewandt ist) angeordnet. Dies eröffnet die Möglichkeit, dass an der Unterseite ein Kühlkörper 18 angekoppelt sein kann. Die Verbindung kann über eine Art Wärmeleitpaste 18w bzw. wärmeleitende Pads oder ein wärmeleitendes Substrat 18b erfolgen. In diesem Fall ist ein wärmeleitendes, elektrisch isoliertes Substrat 18b gewählt.

Entsprechend Ausführungsbeispielen kann für die Verbindung der oberen Lage 24b' zu dem Modul 22 auf unterschiedliche Verbindungstechniken zurückgegriffen werden.

Entsprechend einer ersten Variante kann die gleiche Verbindung verwendet werden wie bei der Lage 24a'. Wichtig ist, dass die Position der Durchführung durch das Modul 22 so gewählt ist, dass nicht ein kritischer Bereich des Moduls 22 berührt wird. Entsprechend einer weiteren Variante könnte ein Stift auf das Modul 22 aufgelötet werden und auch ein Loch in der Verschienung vorgesehen sein, um dann eine ähnliche Kaltpressung zu erreichen. Entsprechend einer dritten alternativen Variante kann diese Stelle mittels Ultraschall- oder Laserschweißen angeschweißt werden.

Bezug nehmend auf Fig. 3a und 3b werden nun weitere Ausführungen erläutert.

Fig. 3a stellt ein Modul 22" dar. Dieses Modul umfasst in einer der oberen Lagen Leistungshalbleiter 22l", die beispielsweise über die Oberseite 22h1" kontaktierbar sind. Zur Kontaktierung der Anschlusspads für DC+ und DC- sind z.B. Spiralfederanschlüsse vorgesehen.

Über solche oder andere Verbindungsmittel kann auch der Ausgang "Out" kontaktiert werden. Zusätzlich können auf der Oberseite 22h1" optionale Elemente wie ein Primary DC-Link oder Driver vorgesehen sein.

Auf der gegenüberliegenden Hauptoberfläche 22h2" ist ein optionaler Dichtring 22d" angeordnet. Zwischen der Hauptoberfläche 22h2" und dem Leistungshalbleitern 22l" können eine oder mehrere keramische Isolatoren 22k" (Si₃N₄-Dicke von beispielsweise 0,25 µm) und Metallisierungslagen 22m"vorgesehen sein. Beispielsweise befindet sich zwischen diesen zwei keramischen Isolatoren 22k"eine Metallisierungslage 22m", die über Vias 22v" in die oberen Lagen, z. B. die Lagen, die mit dem Leistungshalbleiter 22l" in Kontakt sind, leitfähig verbunden ist. An diese Metallisierungslage 22m" wird beispielsweise der DC+ Anschluss über die Vias 22v" angekoppelt. Die Vias 22v" durch den keramischen Isolator 22k" sind aus Herstellungsperspektive nicht optimal. In anderen Worten lässt sich also die Struktur als zweilagiges Keramiksubstrat mit einer Verkapselung (mittels Transfermolding hergestellt) beschreiben. Weitere Details zu diesem Modul 22" sind in der Patentanmeldung 10 2018 1119895 erläutert.

Nachfolgend wird Bezug nehmend auf Fig. 3b dargestellt, wie mittels des Verfahrens zum Kaltpressverschweißen eine Kontaktierung des Leistungshalbleitermoduls 22" erfolgen kann.

Das hier dargestellte Leistungshalbleitermodul 22" ist vergleichbar zu dem in Fig. 3a erläuterten Modul. Es umfasst die ein oder mehreren Leistungshalbleiter 22l", zwei keramischen Lagen 22k" mit der dazwischen liegenden Metallisierung 22m". Auf der ersten Hauptoberfläche 22h1" (die Hauptoberfläche, die der Zwischenkreisverschienung zugewandt ist) weist es eine oder mehrere Metallisierungspads 22p" auf. Die Pads 22p" dienen z.B. zur Kontaktierung von Elementen wie z.B. der Treiber oder formen einen Anschluss (z. B. den Ausgang Out). Die Kontaktierung vom Zwischenkreis DC+ und DC- über die Hauptoberfläche 22h1" wird nachfolgend erläutert.

Wie auch bei dem Ausführungsbeispiel aus Fig. 2 erfolgt die Kontaktierung zu DC+ mittels der Schiene/Lage 24a", die zu der ersten Hauptoberfläche 22h1" direkt benachbart ist. Hierbei ragt ein Pin 24k" aus der Ebene der Schiene 24" heraus und in das Leistungshalbleitersubstrat 22" hinein.

Dadurch, dass der Stift 24k" bis zu der Metallisierungsebene 22m" hineinragt, wird erreicht, dass auf die Durchkontaktierungen durch die Keramik verzichtet werden kann.

Mit einem größeren Abstand zu der Hauptoberfläche 22h1" ist die Lage 24b" angeordnet, nämlich die DC- Kontaktierung. 24a" und 24b" sind wiederum durch einen Isolator 24i" separiert. Die Kontaktschiene 24a" ist am Ende umgefalzt und formt also einen Stift 24k" aus. Dieser ragt in die metallisierte Bohrung 22k" des Substrats 22" hinein. Wie zu erkennen ist, ist die metallisierte Bohrung 22k" elektrisch mit der Metallisierungsschicht 22m" verbunden.

Zur Kontaktierung von DC- (24b") ist auf die Hauptoberfläche 22m" bzw. auf eines der Kontaktpads 22p" ein Stift 22s" aufgebracht. Dieser ist beispielsweise durch einen um 90° gebogenen metallisierten Bereich geformt. Dieser ragt also senkrecht aus der Hauptoberfläche 22h1" heraus, so dass die Schiene 24b" mit einer Bohrung 24bb" ebenfalls mittels Kaltverschweißen kontaktiert werden kann. Hierzu ragt dann also der Stift 22ss" durch die Bohrung 24b" hindurch, wobei wiederum eine plastische Verformung erfolgt. In anderen Worten kann diese Art der Kaltverschweißung dadurch beschrieben werden, dass eine aufgelötete Steckleiste 22ss" mit der DC-Verschienung 24bb" verbunden wird.

Insofern lässt sich dieses Ausführungsbeispiel wie folgt zusammenfassen: Die Zwischenkreisverschienung weist zumindest für eine erste Schiene einen oder mehrere Pins auf, während die Zwischenkreisverschienung für die zweite Schiene eine Bohrung zur Aufnahme eines Pins aufweist. Umgekehrt weist das Leistungsmodul eine Bohrung für den einen oder die mehreren Pins der ersten Schiene auf, während mehrere Pins zur Kontaktierung der zweiten Schiene vorgesehen sind.

Entsprechend weiteren Ausführungsbeispielen können natürlich auch weitere Anschlüsse wie beispielsweise der Out-Anschluss kaltverschweißt werden.

Auch wenn bei obigen Ausführungsbeispielen davon ausgegangen wurde, dass jede Schiene mit einem Stift oder einem ähnlichen Element verschweißt wird, so sei an dieser Stelle darauf hingewiesen, dass entsprechend einem weiteren Ausführungsbeispiel je Schiene auch mehrere Stifte bzw. Elemente bzw. Kaltverschweißungspunkte zum Einsatz kommen können.

Da entsprechend Ausführungsbeispielen die zwei Verschienungen DC- Verschienung und DC+ Verschienung nebeneinander angeordnet sind, ragt die Verschienung hier, die DC-Verschienung, über die DC+ Verschienung hinaus wie z. B. in Fig. 2 und 3b dargestellt ist.

Entsprechend einer Basisausführungsform wird davon ausgegangen, dass die unten liegende Lage über die DC+ Verschienung 24a' bzw. 24a" kaltverschweißt ist. Die Herstellung erfolgt bei dieser Basisvariante wie folgt. Das Kupferblech 24, 24a', 24a" wird so ausgestanzt, dass eine Vielzahl von Stiften, z. B. quadratischen Stiften bzw. näherungsweise quadratischen Stiften entsteht. Diese werden dann umgebogen, z. B. im rechten Winkel. Für die Montage werden die Stifte in dafür vorgesehen metallisierte Bohrungen 22k, 22k', 22k" im Leistungsmodul eingepresst. Dieses Herstellungsverfahren hat die folgenden Vorteile:
Die obere Lage der Verschienung 24b", 24b' muss nicht durchgebohrt werden, um die untere zu montieren. Es erfolgt keine Verbindungstechnik mit Wärmeeintrag. Dennoch ist die Verbindung mechanisch sehr robust und hat sehr geringen elektrischen Widerstand.

Auch wenn bei obigen Ausführungsbeispielen immer davon ausgegangen wurde, dass die DC+ Verschienung durch die Lage geformt ist, die näher an der Oberfläche der Leiterplatte 22, 22', 22" anageordnet ist, so sei an dieser Stelle angemerkt, dass selbstverständlich auch die Lage 24a', 24a" die DC- Verschienung bilden kann.

Ein weiteres Ausführungsbeispiel schafft ein System umfassend die Zwischenkreisverschienung mit einer entsprechenden Verbindungstechnik an das Leistungsmodul angekoppelt sowie die Zwischenkreiskapazitäten. Entsprechend einem weiteren Ausführungsbeispiel kann dann auch noch ein Kühlkörper an dem Leistungsmodul, z. B. an der zweiten Hauptoberfläche, vorgesehen sein.

Bezugnehmend auf die Fig. 4a bis 4c wird nun eine kaltverschweißte Kontaktstelle im Detail erläutert.

Fig. 4a zeigt einen Stift 24k"', der in eine Bohrung 22k'" eingeführt ist. Die Bohrung 22k'" ist mittels einer Kupferschicht metallisiert (siehe Fig. 4b und 4c, Bezugszeichen 22cu'"). In diesem Ausführungsbeispiel weist der Pin 24k'" einen V- oder L-förmigen Querschnitt auf, wobei an den Enden sowie an der Spitze eben die Verbindung zu der Metallisierung 22cu'" erfolgt, die in der vergrößerten Darstellung in Fig. 4c dargestellt ist.

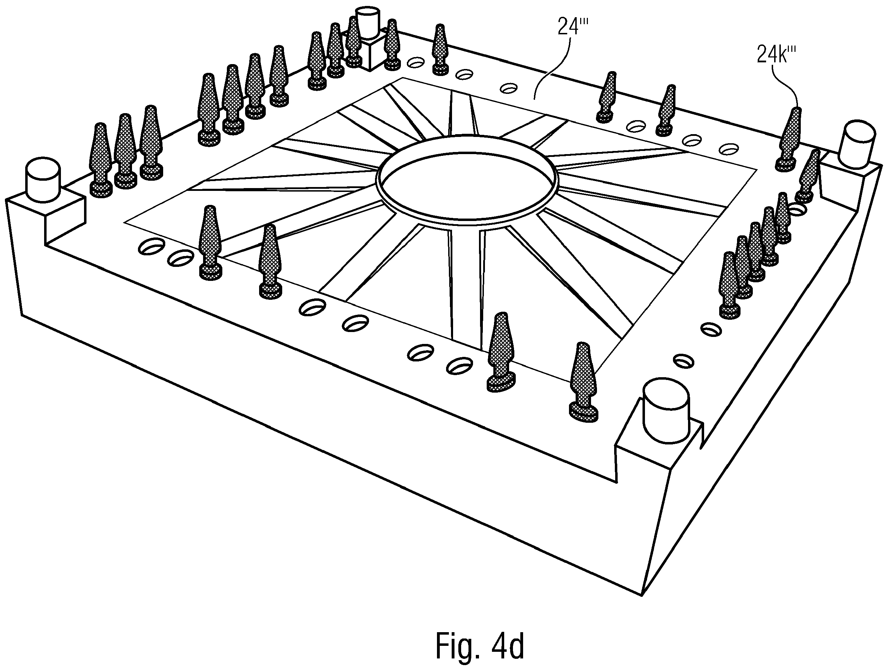

Fig. 4d stellt eine Vielzahl dieser Pins 22k'" dar, die aus einem Element wie z. B. einer Zwischenkreisverschienung 24'" herausragt.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

### Bezugszeichenliste

- 20, 20', 20": System
- 22, 22', 22": Leistungsmodul
- 22I, 22I', 22I": Halbleiter
- 24: Zwischenkreisverschienung
- 24a', 24b', 24a", 24b": Schienen
- 24k, 24k', 24k": Kontaktelemente
- 22k, 22k', 22k": erste Verbindungsstelle

## Patentansprüche

1. System (20, 20', 20") umfassend:
ein Leistungsmodul (22, 22', 22") umfassend einen Halbleiter (22l, 22l', 22l") und eine erste Verbindungsstelle (22k, 22k', 22k") und eine zweite Verbindungsstelle, die mit dem Halbleiter (22l, 22l', 22l") elektrisch leitend verbunden sind;
eine Zwischenkreisverschienung (24) umfassend zumindest zwei Schienen (24a', 24b', 24a", 24b"), wobei eine erste der zwei Schienen (24a', 24b', 24a", 24b") zumindest ein Kontaktelement (24k, 24k', 24k") aufweist, und wobei das zumindest eine Kontaktelement (24k, 24k', 24k") mit der ersten Verbindungsstelle eine elektrisch leitende Kaltverschweißverbindung formt;
wobei das zumindest eine Kontaktelement (24k, 24k', 24k") der ersten der zwei Schienen (24a', 24b', 24a", 24b") zumindest einen Stift aufweist oder wobei das zumindest eine Kontaktelement (24k, 24k', 24k") der ersten der zwei Schienen (24a', 24b', 24a", 24b") zumindest einen Stift mit einem quadratischen Querschnitt, einem runden Querschnitt, einem ovalen Querschnitt oder einem Querschnitt einer anderen Geometrie aufweist; wobei der Stift durch die Leiterplatte (22') oder eine Bohrung oder ein Loch (22k') in den Leistungsmodul 22' hindurchragt.

2. System (20, 20', 20") gemäß Anspruch 1, wobei die elektrisch leitende Kaltverschweißverbindung mittels Kaltverschweißung und/oder Kaltpressverschweißung geformt ist.

3. System (20, 20', 20") gemäß einem der Ansprüche 1 oder 2, wobei die erste Verbindungsstelle (22k, 22k', 22k") zumindest eine metallisierte Bohrung umfasst.

4. System (20, 20', 20") gemäß einem der vorherigen Ansprüche, wobei die erste Verbindungsstelle (22k, 22k', 22k") durch eine Metallisierung (22cu"') der Bohrung (22k') geformt ist.

5. System (20, 20', 20") gemäß Anspruch 4, wobei das eine Kontaktelement (24k, 24k', 24k") zumindest einen Stift aufweist, der sich in dieselbe Richtung erstreckt wie die zumindest eine metallisierte Bohrung, oder wobei das zumindest eine Kontaktelement (24k, 24k', 24k") zumindest einen Stift mit einem quadratischen Querschnitt in einer Ebene aufweist, die senkrecht zu einer Achse der zumindest einen metallisierten Bohrung liegt.

6. System (20, 20', 20") gemäß einem der vorherigen Ansprüche, wobei eine zweite der zwei Schienen (24a', 24b', 24a", 24b") zumindest ein Kontaktelement (24k, 24k', 24k") aufweist, und wobei das zumindest eine Kontaktelement (24k, 24k', 24k") der zweiten der zwei Schienen (24a', 24b', 24a", 24b") mit der zweiten Verbindungsstelle eine elektrisch leitende Verbindung formt.

7. System (20, 20', 20") gemäß Anspruch 6, wobei die leitende Verbindung als Kaltpressschweißverbindung oder Kaltpressschweißverbindung ausgeführt ist.

8. System (20, 20', 20") gemäß Anspruch 6 oder 7, wobei die Verbindungsstelle der zweiten der zwei Schienen (24a', 24b', 24a", 24b") zumindest einen Stift umfasst und das zumindest eine Kontaktelement (24k, 24k', 24k") der zweiten der zwei Schienen (24a', 24b', 24a", 24b") eine Bohrung aufweist oder wobei die zumindest eine Verbindungsstelle der zweiten der zwei Schienen (24a', 24b', 24a", 24b") eine Bohrung aufweist und wobei das zweite Kontaktelement (24k, 24k', 24k") zumindest einen Stift aufweist.

9. System (20, 20', 20") gemäß Anspruch 6, wobei die elektrisch leitende Verbindung eine Oberflächenverbindung, Schweißverbindung, Ultraschallschweißverbindung oder Laserschweißverbindung umfasst.

10. System (20, 20', 20") gemäß einem der vorherigen Ansprüche, wobei die Kaltverschweißverbindung (Zwischenkreisverbindung) zumindest zwei leitende Lagen mit einer dazwischen liegenden Isolationsschicht umfasst, wobei die erste der zwei leitenden Lagen die erste der zwei Schienen (24a', 24b', 24a", 24b") formt und die zweite der zwei leitenden Lagen die zweite der zwei Schienen (24a', 24b', 24a", 24b") formt.

11. System (20, 20', 20") gemäß Anspruch 10, wobei die zweite der zwei leitenden Lagen an einem Ende der Zwischenkreisverschienung (24) über die erste der der zwei leitenden Lagen hinausragt.

12. System (20, 20', 20") gemäß einem der vorherigen Ansprüche, wobei das Leistungsmodul (22, 22', 22") eine erste Hauptoberfläche aufweist, die der Zwischenkreisverschienung (24) zugewandt ist, wobei zumindest die zweite Verbindungsstelle auf der ersten Hauptoberfläche vorgesehen ist.

13. System (20, 20', 20") gemäß einem der Ansprüche 10, 11 oder 12, wobei die elektrisch leitende Kaltverschweißverbindung eine Oberflächenverbindung, Schweißverbindung, Ultraschallschweißverbindung oder Laserschweißverbindung ist und wobei die zweite der zwei Schienen (24a', 24b', 24a", 24b") eine Kröpfung aufweist und die Kröpfung so geformt ist, dass sie unter Berücksichtigung der Dicke der ersten leitenden Lage und der Dicke der Isolierschicht den Abstand zwischen der ersten der zwei leitenden Lagen und der ersten Hauptoberfläche des Leistungsmoduls (22, 22', 22"), die der Zwischenkreisverschienung (24) zugewandt ist, definiert.

14. System (20, 20', 20") gemäß einem der vorherigen Ansprüche, wobei das System (20, 20', 20") ein oder mehrere Kapazitäten umfasst, die über die Zwischenkreisverschienung (24) mit dem Leistungsmodul (22, 22', 22") elektrisch leitend verbunden sind.

15. System (20, 20', 20") gemäß einem der vorherigen Ansprüche, wobei das Leistungsmodul (22, 22', 22") zwei in Reihe geschaltete Halbleiter (22l, 22l', 22l") in Form einer Halbbrücke oder in Form einer Schalter-Dioden-Kombination aufweist.

16. System (20, 20', 20") gemäß einem der Ansprüche 6 bis 15, wobei die elektrisch leitende Kaltverschweißverbindung und die elektrisch leitende Verbindung mit unterschiedliche Verbindungstechniken verbunden ist.

17. System (20, 20', 20") gemäß einem der vorherigen Ansprüche, wobei eine Erstreckungsrichtung des Stiftes und/oder der Bohrung oder des Lochs (22k') gegenüber einer Erstreckungsrichtung eines Kontaktelements (24k, 24k', 24k") der zweiten der zwei Schienen (24a', 24b', 24a", 24b") unterschiedlich ist.

18. Verfahren zur Herstellung eines Systems (20, 20', 20") gemäß einem der vorherigen Ansprüche, wobei das Verfahren den Schritt des elektrisch Kontaktierend des zumindest einen Kontaktelements (24k, 24k', 24k") mit der ersten Verbindungsstelle mittels Kaltverschweißens und/oder Kaltpressverschweißen umfasst, so dass eine Kaltverschweißverbindung ausgebildet wird.

19. Verfahren gemäß Anspruch 18, wobei das Verfahren den Schritt des Einpressens zumindest eines Stifts, der das Kontaktelement (24k, 24k', 24k") der ersten der zwei Schienen (24a', 24b', 24a", 24b") formt, in zumindest eine metallisierte Bohrung des Leistungsmoduls (22, 22', 22") umfasst.
